# Europäisches Patentamt

## European Patent Office

## Office européen des brevets

(19)

(11) Veröffentlichungsnummer: **0 309 867 B1**

(12) **EUROPÄISCHE PATENTSCHRIFT**

(45) Veröffentlichungstag der Patentschrift: **02.12.92**

(21) Anmeldenummer: **88115392.8**

(22) Anmeldetag: **20.09.88**

(51) Int. Cl.⁵: **H03K 17/04**, H02M 3/335, H02M 3/338

(54) **Schaltnetzteil.**

(30) Priorität: **29.09.87 DE 3732790**

(43) Veröffentlichungstag der Anmeldung:
**05.04.89 Patentblatt 89/14**

(45) Bekanntmachung des Hinweises auf die
Patenterteilung:
**02.12.92 Patentblatt 92/49**

(84) Benannte Vertragsstaaten:
**AT BE CH DE ES FR GB GR IT LI LU NL SE**

(56) Entgegenhaltungen:
**EP-A- 0 122 907**
**EP-A- 0 200 600**
**EP-A- 0 211 300**
**GB-A- 2 186 138**

(73) Patentinhaber: **Deutsche Thomson-Brandt GmbH**
**Hermann-Schwer-Strasse 3 Postfach 1307**
**W-7730 Villingen-Schwenningen(DE)**

(72) Erfinder: **Rilly, Gerard, Dr. Ing.**
**Panoramaweg 6**
**W-7731 Unterkirnach(DE)**
Erfinder: **Rodriguez, Josè, Dipl.-Ing.**
**Brendweg 16**
**W-7730 VS-Villingen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 309 867 B1

## Beschreibung

Die Erfindung betrifft ein Schaltnetzteil zur Erzeugung verschiedener Betriebsspannung aus der Netzspannung, insbesondere für Fernsehempfänger, Videorecorder, Personalcomputer und dergleichen. Ein derartiges Schaltnetzteil ist bekannt durch EP-A2-0 211 300.

Ein Schaltnetzteil enthält im allgemeinen einen Schalttransistor, der über die Arbeitswicklung eines Transformators an eine aus der Netzspannung gewonnene Betriebsspannung angeschlossen ist. Der Schalttransistor wird durch eine Steuerspannung periodisch leitend gesteuert und gesperrt. Die Steuerspannung kommt z.B. von einem auf der Primärseite vorgesehenen Oszillator oder wird von der Sekundärseite über einen Transformator auf die Primärseite übertragen. Vorzugsweise ist die Steuerspannung im Sinne einer Pulsweitenmodulation (PWM) in Abhängigkeit von der Amplitude der erzeugten Betriebsspannung so moduliert, daß die Stromflußdauer durch den Schalttransistor im Sinne einer Stabilisierung der Ausgangsspannungen geändert wird.

Bei einer solchen Schaltung hat sich gezeigt, daß nach dem Einschalten der Schaltung beim Auftreten der Steuerspannung das Einschalten des Schalttransistors einwandfrei funktioniert, daß jedoch das Ausschalten in den gesperrten Zustand insbesondere auf Grund von Ausräumeffekten unbefriedigend ist. Es kommt insbesondere zu einer unzulässig langen Einschaltzeit des Schalttransistors, so daß der während der Einschaltzeit etwa linear ansteigende Strom durch den Schalttransistor und die Arbeitswicklung des Transformators und somit die beim Abschalten des Stromes auftretenden Spannungen am Transformator unzulässig hohe Werte annehmen.

Der Erfindung liegt die Aufgabe zugrunde, mit einfachen Schaltungsmitteln zu bewirken, daß unmittelbar nach dem Einschalten der Schaltung auch das Ausschalten des Schalttransistors einwandfrei erfolgt.

Diese Aufgabe wird durch die im Anspruch 1 beschriebene Erfindung gelöst. Eine vorteilhafte Weiterbildungen der Erfindung ist im Unteranspruch beschrieben.

Die auf einfache Weise aus der Netzspannung gewonnene, im Sinne einer Sperrung des Schalttransistors wirkende, vorzugsweise negative Vorspannung bewirkt also, daß nach dem Einschalten des gesamten Schaltnetzteils nicht nur das Einschalten, sondern auch das Ausschalten des Schalttransistors einwandfrei erfolgt und keine unzulässig hohen Ströme und Spannungen an dem Transformator auftreten. Die Vorspannung muß in voller Höhe vorhanden sein, wenn die Steuerspannung nach dem Einschalten des Schaltnetzteils auftritt. Diese Bedienung läßt sich mühelos einhalten, weil im allgemeinen im Weg der Betriebsspannung für die Schaltung zur Erzeugung der Steuerspannung große Zeitkonstanten wirksam sind und somit die Steuerspannung mit einer relativ großen Verzögerung von 1s auftritt. Die Vorspannung wirkt somit wie eine Batterie mit während der entscheidenden Zeit konstanter Spannung, die das Verhalten des Schaltnetzteils hinsichtlich der Steuerung des Schalttransistors nach dem Einschalten beträchtlich verbessert.

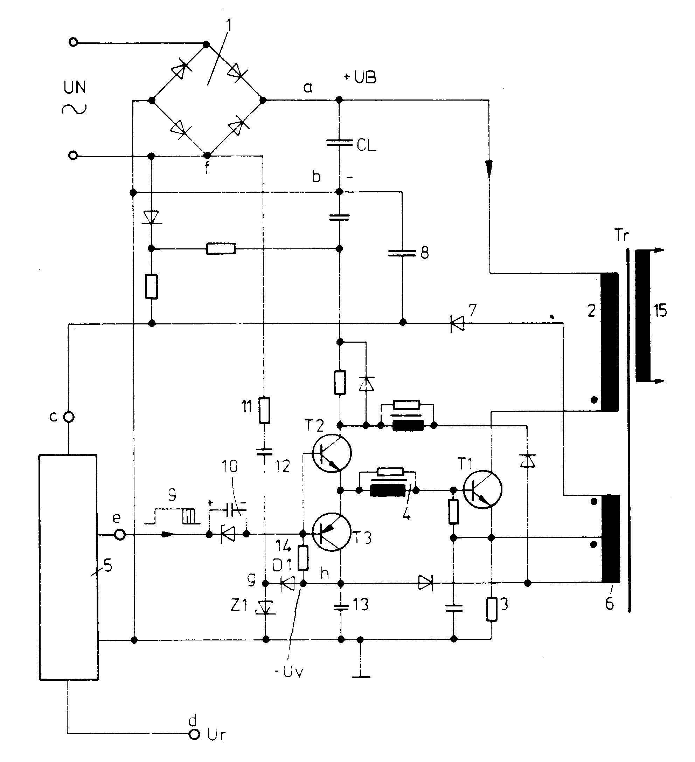

Die Erfindung wird an Hand der Zeichnung an einem Ausführungsbeispiel erläutert. Die Figur zeigt in vereinfachter Form die Primärseite eines mit der Netzspannung gespeisten Schaltnetzteils.

In der Figur wird aus der Netzspannung UN, die sich zwischen 90 V und 260 V ändern kann, mit dem Netzgleichrichter 1 die Betriebsspannung +UB zwischen den Punkten a und b gewonnen, die über die Arbeitswicklung 2 des Transformators Tr an den Schalttransistor T1 angelegt ist. Dessen Emitter ist über den niederohmigen Widerstand 3 mit der primärseitigen Erde verbunden. Der Schalttransistor T1 wird von der Treiberschaltung mit den Transistoren T2, T3 über das Netzwerk 4 gesteuert. Auf der Primärseite ist die Steuerschaltung 5 vorgesehen. Diese erhält an der Klemme c eine Betriebsspannung, die durch Gleichrichtung der an der Wicklung 6 stehenden Impulsspannung mit dem Gleichrichter 7 und dem Kondensator 8 gewonnen ist. An der Klemme d ist der Steuerschaltung 5 eine Regelspannung Ur zugeführt, die auf der Sekundärseite aus der Höhe der erzeugten Betriebsspannung gewonnen ist und die Impulsbreite der an der Klemme e gewonnenen Steuerspannung 9 im Sinne einer Stabilisierung der Betriebsspannungen moduliert. Die Steuerspannung gelangt über das Vorspannungs-Netzwerk 10 auf die Basen der Treibertransistoren T2, T3 und bewirkt eine periodische Einschaltung und Ausschaltung des Schalttransistors T1.

Die Netzspannung UN vom Punkt f des Netzgleichrichters 1 ist über den Widerstand 11 und den Kondensator 12 an die Zenerdiode Z1 mit einer Zenerspannung von 3,9 V angelegt. Dadurch entstehen am Punkt g negative Impulse mit einer Amplitude von 3,9 V. Diese Impulse werden mit der Diode D1 gleichgerichtet und erzeugen am Punkt h an dem Kondensator 13 eine negative Vorspannung -Uv von 3,5 V. Die Vorspannung gelangt über den Widerstand 14 auf die Basen der beiden Transistoren T2,T3. Die negative Vorspannung -Uv wirkt im Sinne eines leitenden Transistors T3 und eines gesperrten Transistors T2. Das bedeutet, daß die Vorspannung -Uv auf den Schalttransistors T1 im Sinne einer Sperrung einwirkt. Die Vorspannung -Uv ist in voller Höhe vorhanden, bevor die Steuerspannung 9 auftritt und den Schalttransistor T1 steuert. Sie bewirkt, daß beim Auftreten der Steuerspannung 9 bereits eine einwandfreie Steuerung des Schalttransistors T1 erfolgt, in dem Sinne, das dieser einwandfrei eingeschaltet und auch einwandfrei gesperrt wird und keine unzulässig hohen Ströme oder Spannungen am Transformator Tr auftreten. Der Transformator Tr liefert mittels mehrerer Sekundärwicklungen 15 und zugehöriger Gleichrichterschaltungen Betriebspannungen unterschiedlicher Größe und Polarität.

## Patentansprüche

1. Schaltnetzteil, bei dem eine aus der Netzspannung (UN) gewonnene Betriebsspannung (UB) über eine Arbeitswicklung (2) eines Transformators (Tr) an einen Schalttransistor (T1) angelegt und an dessen Basis der Ausgang einer Treiberschaltung (T2, T3) über eine Gleichspannungskopplung (4) angeschlossen ist, wobei an den Steuereingang der Treiberschaltung (T2, T3) eine Steuerspannung (9) für den Schalttransistor (T1) angelegt ist, **dadurch gekennzeichnet,** daß aus der Netzspannung (UN) mit einem Gleichrichter (D1) eine Gleichspannung (-Uv) gewonnen und diese mit einer Polarität im Sinne einer Sperrung des Schalttransistors (T1) an den Steuereingang der Treiberschaltung (T2, T3) angelegt ist, wobei nach dem Einschalten des Schaltnetzteils die gewonnene Gleichspannung (-Uv) vorhanden ist, bevor die Steuerspannung (9) auftritt.

2. Schaltnetzteil nach Anspruch 1, **dadurch gekennzeichnet,** daß ein die Netzspannung (UN) führender Punkt (f) über ein RC-Glied (11,12) an eine Zenerdiode (Z1) und an diese der Eingang des Gleichrichters (D1) angeschlossen ist.

## Claims

1. Switched power supply in which an operating voltage (UB) obtained from the mains voltage (UN) is applied via a working winding (2) of a transformer (Tr) to a switching transistor (T1) and the output of a driver circuit (T2, T3) is connected via a direct voltage coupling (4) to its base, wherein a control voltage (9) for the switching transistor (T1) is applied to the control input of the driver circuit (T2, T3), characterised in that, a direct voltage (-Uv) is obtained from the mains voltage (UN) by a rectifier (D1) and this is applied to the control input of the driver circuit (T2, T3) in the sense of a blocking of the switching transistor (T1), wherein after the turning-on of the switched power supply, the direct voltage (-Uv) which has been obtained is available before the control voltage (9) appears.

2. Switched power supply in accordance with Claim 1, characterised in that, a point (f) carrying the mains voltage (UN) is connected via an RC member (11, 12) to a Zener diode (Z1) and the input of the rectifier (D1) is connected to the latter.

## Revendications

1. Bloc d'alimentation et de commutation dans lequel une tension de fonctionnement (UB) obtenue à partir de la tension de secteur (UN) est appliquée, par un enroulement de travail (2) d'un transformateur (Tr) à un transistor de commutation (T1) et à la base duquel la sortie d'un circuit d'attaque (T2, T3) est branchée par un couplage à tension continue (4), une tension de commande (9) pour le transistor de commutation (T1) étant appliquée à l'entrée de commande du circuit d'attaque (T2, T3), **caractérisé en ce** qu'une tension continue (-Uv) est obtenue à partir de la tension de secteur (UN) avec un redresseur de courant (D1) et que cette tension est appliquée à l'entrée de commande du circuit d'attaque (T2, T3) avec une polarité dans le sens d'un blocage du transistor de commutation (T1), la tension continue obtenue (-Uv) étant existante après la mise en circuit du bloc d'alimentation et de commutation avant que la tension de commande (9) intervienne.

2. Bloc d'alimentation et de commutation selon la revendication 1, **caractérisé en ce** qu'un point (f) qui guide la tension de secteur (UN) est branché sur une diode Zener (Z1) par un circuit RC (11, 12) et que l'entrée du redresseur de courant (D1) est branchée sur cette diode Zener.

EP 0 309 867 B1

4